# EUROPEAN PATENT APPLICATION

(11) **EP 4 746 288 A1**
(43) Date of publication of application: **20.05.2026**
(21) Application number: 25175223.4
(22) Date of filing: 09.05.2025
(51) Int. Cl.: H03F 1/30, G05F 3/22, H03F 3/195, H03F 3/24

(54) **POWER AMPLIFIER WITH VARIABLE POWER SUPPLY VOLTAGE**

(30) Priority: 14.11.2024 US 202418948351
(71) Applicant: GlobalFoundries U.S. Inc., Malta, NY 12020 (US)
(72) Inventor: Bellaouar, Abdellatif, Richardson, 75082 (US); Zhang, Chi, Richardson, 75081 (US); Lu, Liyou, Gilbert, 85297 (US)
(74) Representative: Grünecker Patent- und Rechtsanwälte PartG mbB

(57) **Abstract**

Disclosed is a circuit structure including a power amplifier and a temperature-dependent power supply system for the power amplifier. The power supply system includes a first voltage generator, which generates a reference voltage that is variable and depends on the operating temperature. In some embodiments, this first voltage generator employs a combination of proportional-to-absolute-temperature and constant-to-absolute temperature current sources to achieve the desired relationship between the operating temperature and the reference voltage. In other embodiments, a look-up table is employed to achieve the desired relationship between the operating temperature and the reference voltage. In any case, the power supply system also includes a second voltage generator, which is connected to receive the reference voltage and which generates (and outputs to the power amplifier) a power supply voltage that is dependent on the reference voltage.

## Description

### BACKGROUND

The present disclosure relates to power amplifiers and, more particularly, to embodiments of a circuit including a power amplifier with a variable power supply voltage.

In power amplifiers, and particularly, power amplifiers incorporated into radio frequency (RF) applications (e.g., high frequency RF applications, such as mmWave applications), performance specifications may include a relatively high saturation power (Psat) and a relatively high power added efficiency (PAE). In a typical power amplifier, the power supply voltage (Vdd) can be increased in order to increase both Psat and PAE. However, to avoid violating reliability specifications for the power amplifier and devices therein, Vdd can only be set at some maximum voltage level (Vdd_max). Furthermore, even with Vdd_max, if the operating temperature of the power amplifier increases, Psat and PAE tend to drop.

### SUMMARY

Disclosed herein are embodiments of a circuit structure. The circuit structure can include a power amplifier and a temperature-dependent power supply system for the power amplifier. The power supply system can include a first voltage generator, which generates a reference voltage dependent on an operating temperature. The power supply system can also include a second voltage generator, which is connected to receive the reference voltage and which generates a power supply voltage dependent on the reference voltage. The power amplifier can be connected to receive the power supply voltage.

Some embodiments of a circuit structure disclosed herein can include a power amplifier and a temperature-dependent power supply system for the power amplifier. The power supply system can include a first voltage generator. The first voltage generator can include a reference voltage output node. The first voltage generator can also include: a primary proportional-to-absolute-temperature (PTAT) current source, which provides a primary PTAT current; and a primary constant-to-absolute-temperature (CTAT) current source, which provides a primary CTAT current. The primary PTAT current source and the primary CTAT current source can be connected in parallel between a first voltage rail and the reference voltage output node. The first voltage generator can further include a resistor, which is connected between the reference voltage output node and a second voltage rail. The first voltage generator can generate, at the reference voltage output node, a reference voltage dependent on an operating temperature. The power supply system can also include a second voltage generator, which is connected to receive the reference voltage and which generates a power supply voltage dependent on the reference voltage. The power amplifier can be connected to receive the power supply voltage.

Other embodiments of a circuit structure disclosed herein can include a power amplifier and a temperature-dependent power supply system for the power amplifier. The power supply system can include a first voltage generator. The first voltage generator can include a temperature sensor and a variable voltage source. The first voltage generator can also include a look-up table populated with a list of different operating temperatures and different reference voltages associated with the different operating temperatures, respectively. The first voltage generator can also include control logic, which is connected the temperature sensor, the look-up table and the variable voltage source and which causes the variable voltage source to output a reference voltage listed in the look-up table and associated with an operating temperature sensed the temperature sensor such that the reference voltage is dependent on the operating temperature. The power supply system can also include a second voltage generator, which is connected to receive the reference voltage and which generates a power supply voltage dependent on the reference voltage. The power amplifier can be connected to receive the power supply voltage.

It should be noted that all aspects, examples, and features of disclosed embodiments mentioned in the summary above can be combined in any technically possible way. That is, two or more aspects of any of the disclosed embodiments, including those described in this summary section, may be combined to form implementations not specifically described herein. The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIG. 1A is a schematic diagram illustrating an example of a power amplifier (PA);
FIG. 1B is a graph illustrating an inverse relationship between temperature and both saturation power (Psat) and power added efficiency (PAE) in the PA of FIG. 1A
FIG. 2 is a schematic diagram illustrating disclosed embodiments of circuit structure;
FIG. 3 is a graph illustrating voltage swings at different operating temperatures when using a fixed power supply voltage;
FIG. 4 is a graph illustrating voltage swings at different operating temperatures when using a temperature-dependent power supply voltage;
FIG. 5 is a graph comparing a temperature-dependent drop in Psat when using a fixed power supply voltage to a temperature-dependent drop in Psat when using a temperature-dependent power supply voltage;
FIG. 6 is a graph comparing a temperature-dependent drop in PAE when using a fixed power supply voltage to a temperature-dependent drop in PAE when using a temperature-dependent power supply voltage;
FIG. 7 is a schematic diagram illustrating one example of a first voltage generator that could be incorporated into the power supply system of the circuit structure of FIG. 2; and
FIG. 8 is a schematic diagram illustrating another example of a first voltage generator that could be incorporated into the power supply system of the circuit structure of FIG. 2.

### DETAILED DESCRIPTION

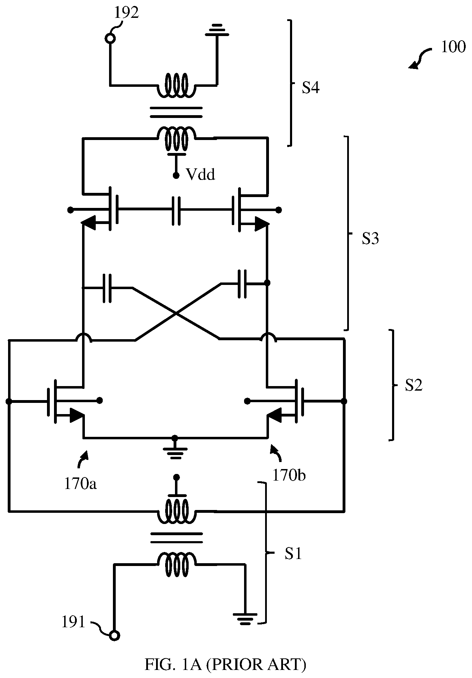

FIG. 1A is a schematic diagram illustrating one example of a power amplifier (PA) 100 suitable for use in RF applications (e.g., high frequency RF applications, such as in mmWave applications). PA 100 includes an RF input stage (S1), a drive stage (S2), a power stage (S3), and an RF output stage (S4) and, within the drive stage (S2) and the power stage (S3), two symmetric parallel branches 170a and 170b (also referred to herein as symmetric parallel branches), each connected at one end to the RF input stage (S1) and at the opposite end to the RF output stage (S4). RF input stage (S1) can be connected to receive an RF input signal at an input node 191. Drive stage (S2) can be connected between RF input stage (S1) and power stage (S3) and can regulate current flow through the PA. Power stage (S3) can be connected between drive stage (S2) and RF output stage (S4) and can amplify the RF input signal, converting it from a lower power RF signal to a higher power RF signal (e.g., by increasing the large-signal voltage swing across transistors within the power stage (S3)). RF output stage S4 can be connected to power stage (S3) and can be configured to receive and output the higher power output signal (i.e., the RF output signal) at an output node 192 as well as to provide impedance matching for the RF output signal at the output node 192.

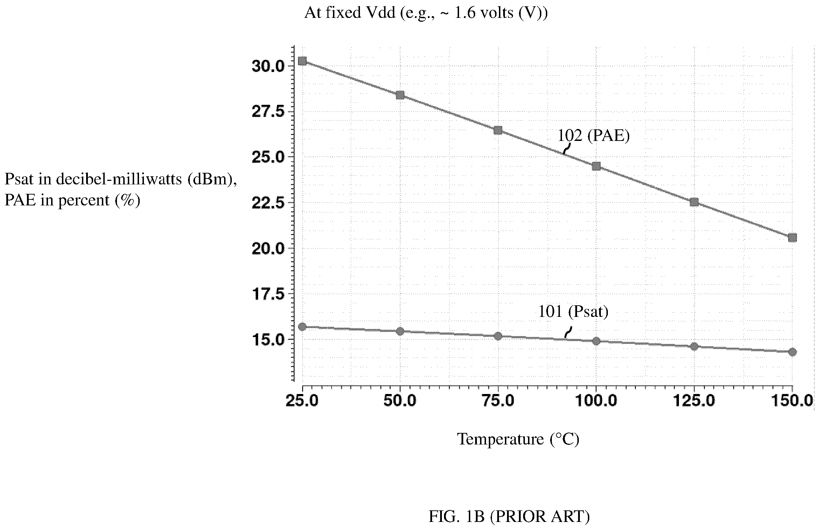

Performance specifications of such a PA 100 may include a relatively high saturation power (Psat) and a relatively high power added efficiency (PAE). Those skilled in the art will recognize that Psat refers to the decibel-milliwatts (dBm) level at which the amplifier is saturated. That is, as the input power (Pin) of an input radio frequency signal (RFin) increases, the output power (Pout) of the output radio frequency signal (RFout) will also increase until Pout reaches Psat (i.e., a compression point where no further gain is exhibited). PAE refers to the ratio (in percent (%)) of the difference between Pout and Pin and the total power consumed. In a typical PA, such as PA 100 of FIG. 1A, the power supply voltage (Vdd) can be increased in order to increase both Psat and PAE. However, to avoid violating reliability specifications for the power amplifier and devices therein, Vdd can only be set at some maximum voltage level (Vdd_max). Furthermore, even if Vdd_max is used as the power supply for PA 100, if the operating temperature of the power amplifier increases, Psat and PAE tend to drop. For example, as illustrated by dBm-temperature curve 101 in FIG. 1B, between 25°C and 150°C, Psat could drop by ~1.4dBm. Additionally, as illustrated by %-temperature curve 102 in FIG. 1B, between 25°C and 150°C, PAE could drop by ~10% points.

In view of the foregoing, disclosed herein are embodiments of a circuit structure that includes a power amplifier and a temperature-dependent power supply system for powering the power amplifier. Specifically, the temperature-dependent power supply system can include a first voltage generator, which can generate a reference voltage that is variable and depends on the operating temperature. For example, the reference voltage can vary from a base reference voltage level when the operating temperature is at a nominal operating temperature level and can increase to progressively higher reference voltage levels as the operating temperature increases to progressively higher temperature levels beyond the nominal operating temperature level. In some embodiments, this first voltage generator can employ a combination of proportional-to-absolute-temperature (PTAT) and constant-to-absolute temperature (CTAT) current sources to achieve the desired relationship between the operating temperature and the reference voltage. In other embodiments, a look-up table can be employed to achieve the desired relationship between the operating temperature and the reference voltage. In any case, the temperature-dependent power supply system can further include a second voltage generator, which is connected to receive the reference voltage and which generates (and outputs to the power amplifier) a power supply voltage that is dependent on the reference voltage. For example, the power supply voltage can be at a base power supply voltage level when the reference voltage is at the base reference voltage level and can change to progressively higher power supply voltage levels as the reference voltage changes to the progressively higher reference voltage levels. The relationship between the temperature-dependent reference voltage and the reference voltage-dependent power supply voltage can be such that as the operating temperature of the amplifier varies across a range of operating temperatures, voltage swings of the power amplifier at different operating temperatures have maximum voltage levels that are approximately equal. As discussed in greater detail below, by varying the power supply voltage to the power amplifier in this manner, the embodiments can reduce temperature-dependent Psat and PAE losses without risking reliability specification violations.

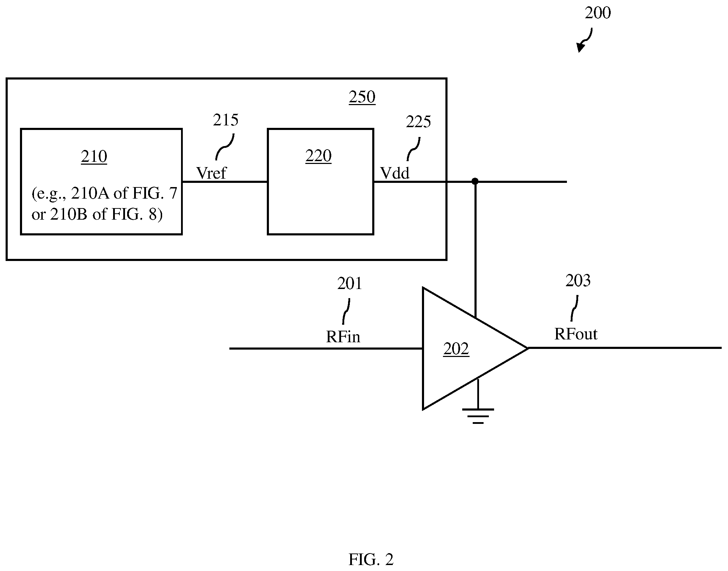

More particularly, FIG. 2 is a schematic diagram illustrating disclosed embodiments of circuit structure 200 (hereinafter referred to as structure 200).

Structure 200 can include a power amplifier (PA) 202. PA 202 can be connected to receive a low power radio frequency signal (RFin) 201 and can be configured to output a higher power radio frequency output signal (RFout) 203. PA 202 can be, for example, a power amplifier suitable for use in RF applications (e.g., in high frequency RF applications, such as a mmWave application). In some embodiments, PA 202 can be configured in essentially the same manner as example PA 100 illustrated in FIG. 1A and described above. Alternatively, PA 202 could have any other suitable PA configuration now known or subsequently developed.

Structure 200 can further include a temperature-dependent power supply system 250 (hereinafter referred to as PSS 250) for powering PA 202. PSS 250 can include a pair of voltage generators and, particularly, a first voltage generator 210 (e.g., 210A or 210B depending upon the embodiment and discussed in greater detail below) and a second voltage generator 220.

First voltage generator 210 can generate a reference voltage (Vref) 215, which is variable with a particular temperature-dependent Vref profile. Specifically, Vref 215 can vary as function of the operating temperature of structure 200 and, more particularly, of PA 202. For example, first voltage generator 210 can be configured to generate and output Vref 215 with the following temperature-dependent Vref profile: (a) Vref 215 is at a base voltage level when the operating temperature is at a nominal operating temperature level (Tn); (b) Vref 215 changes (e.g., continually, or by steps) to progressively higher reference voltage levels up to some maximum reference voltage level as the operating temperature rises to progressively higher temperature levels above Tn; and (c) Vref 215 changes to progressively lower reference voltage levels back down to the base reference voltage level as the operating temperature drops back down to Tn. The nominal operating temperature (Tn) can be, for example, the typical or intended operating temperature for the PA (e.g., room temperature of around 25°C).

Second voltage generator 220 can generate a power supply voltage (Vdd) 225, which is variable with a particular Vref-dependent Vdd profile. Specifically, second voltage generator 220 can be connected to receive Vref 215 and can further be configured to generate and output Vdd 225 with the following Vref-dependent Vdd profile: (a) Vdd 225 is at a base power supply voltage level when Vref 215 is at the base reference voltage level; (b) Vdd 225 changes to progressively higher power supply voltage levels up to some maximum power supply voltage level as Vref changes to progressively higher reference voltage levels; and (c) Vdd 225 changes to progressively lower power supply voltage levels down to the base power supply voltage level as Vref changes to progressively lower reference voltage levels down to the base reference voltage level.

First voltage generator 210 and second voltage generator 220 can further be configured (in combination) so that the relationships between the operating temperature and Vref 215 and between Vref 215 and Vdd 225 result in PA 202 having voltage swings at different operating temperatures with essentially the same peak voltage level. That is, given the temperature-dependent Vref 215 and the Vref-dependent Vdd 225, peak voltage levels of voltage swings associated with different operating temperatures across a range of operating temperatures will be approximately equal.

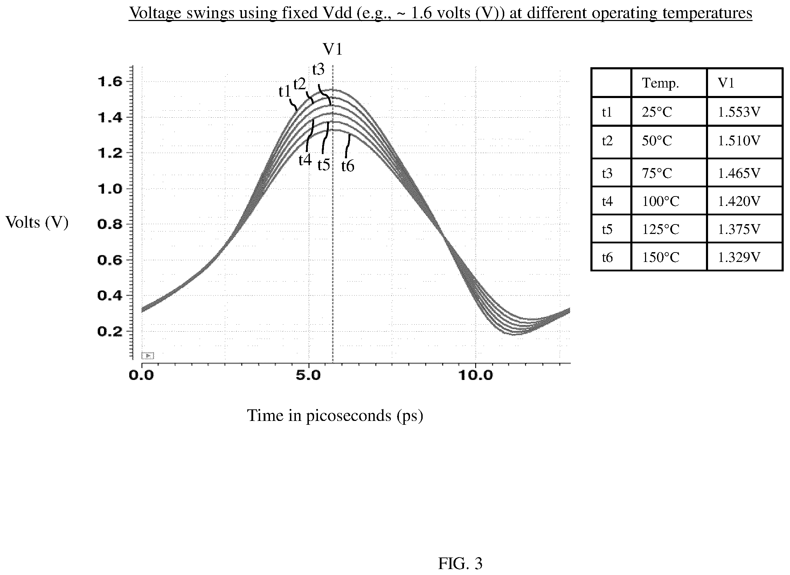

As background, the voltage swing of a power amplifier refers to the voltage range of the power output signal, as measured over time. This voltage swing can be different for different operating temperatures. For example, when a power amplifier is powered with a fixed power supply voltage (Vdd_fixed), voltage swings associated with different operating temperatures can have different peak voltage levels. FIG. 3 is a graph showing curves representing different voltage swings exhibited by a power amplifier at different operating temperatures t1-t6, respectively, when the power amplifier is powered by a fixed power supply voltage (as is conventionally the case), and t1<t2<t3<t4<t5<t6. As illustrated, the peak voltage level (indicated by V1) of each voltage swing at each different operating temperature is different. Specifically, V1 is highest (e.g., at 1.553V) for the voltage swing at t1 (e.g., 25°C) and V1 is lowest (e.g., at 1.329V) for the voltage swing at t6 (e.g., 150°C). Generally, regardless of temperature, if V1 is too high (i.e., is above some maximum peak voltage level), a power amplifier will suffer from reliability issues. Since V1 is dependent, at least in part, on Vdd, the fixed power supply voltage employed to power the power amplifier is typically set low enough to ensure that V1 remains below the maximum peak voltage level regardless of operating temperature. For example, as shown in FIG. 3, the fixed power supply voltage could be set at 1.6 volts (V) to ensure that V1 associated with the voltage swing at any given operating temperature is within a range of operating temperatures (including V1 associated with the voltage swing at the lowest operating temperature t1) remains at or below a maximum peak voltage level (e.g., 1.565V) established to avoid reliability issues.

However, in the disclosed structure embodiments, the drop in the peak voltage levels of voltage swings exhibited at higher temperatures can be exploited to allow for a boost Vdd and, thereby a boost performance. Specifically, referring again to FIG. 1, as mentioned above in the disclosed embodiments, first voltage generator 210 of PSS 250 generates and outputs Vref 215 with the above-described temperature-dependent Vref profile and second voltage generator 220 generates and outputs Vdd 225 with the above-described Vref-dependent Vdd profile. As a result, the peak voltage levels of voltage swings of PA 202 at operating temperature levels above Tn rise close to (without exceeding) the maximum peak voltage level at which PA 202 becomes susceptible to reliability issues.

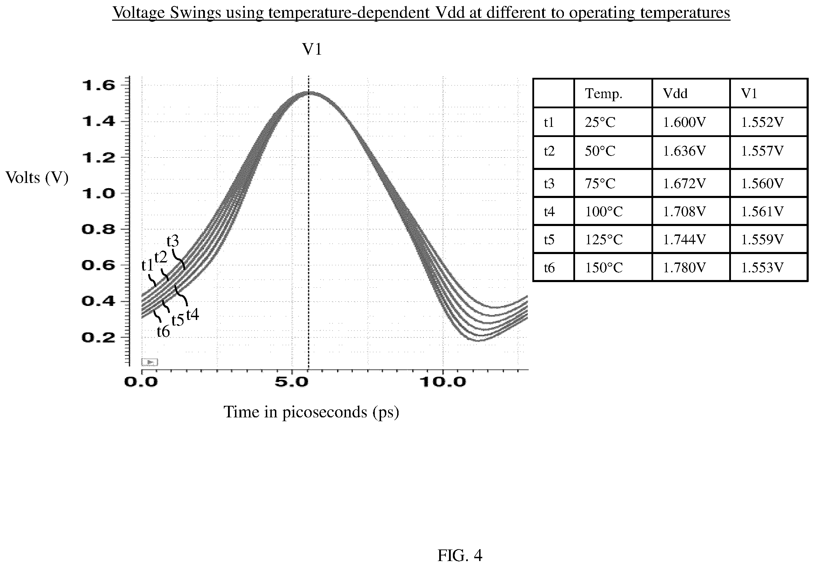

FIG. 4 is a graph showing curves representing different voltage swings exhibited by PA 202 at progressively higher operating temperatures t1-t6, when PA 202 is powered by Vdd 225 at progressively higher supply voltage levels. As illustrated, Vdd ranges from 1.6 V at t1 (e.g., at 25 °C) to 1.780 V at t6 (e.g., at 150 °C) and the peak voltage levels of the voltage swings at t1-t6 remain steady (i.e., essentially equal at 1.55 V +/- .015 V) and below the maximum peak voltage level (e.g., 1.565 V).

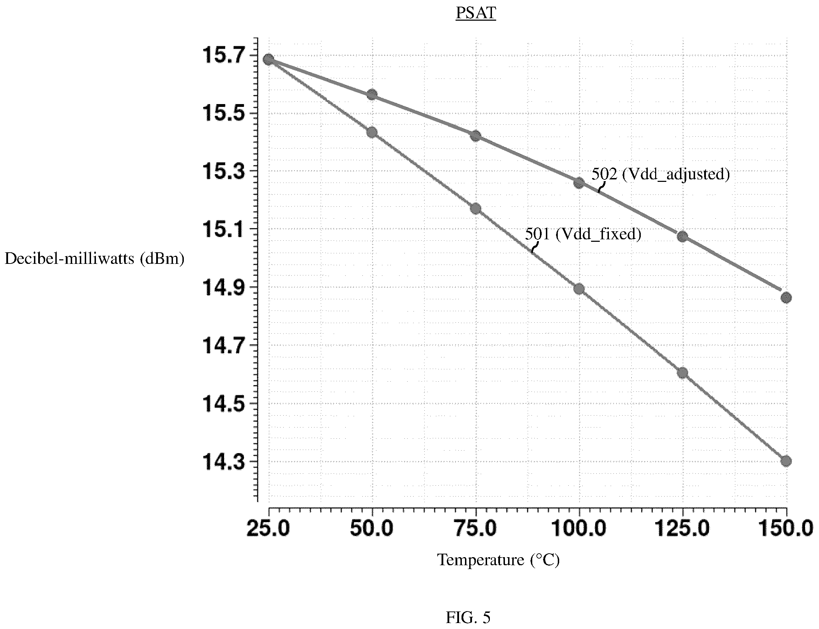

FIG. 5 is a graph showing that a temperature-dependent drop in Psat, between 25 °C and 150 °C, can be reduced significantly with Vdd boosting at higher operating temperatures as described above (see the dBm-temperature curve 502) as compared to without such Vdd boosting (see the dBm-temperature curve 501). For example, as illustrated, the drop in Psat may be as much as ~1.4dBm when using a fixed Vdd across the range of operating temperatures from t1 (e.g., 25 °C) to t6 (e.g., 150 °C) and may be reduced to ~.8 dBm when boosting the voltage level of Vdd at higher operating temperatures.

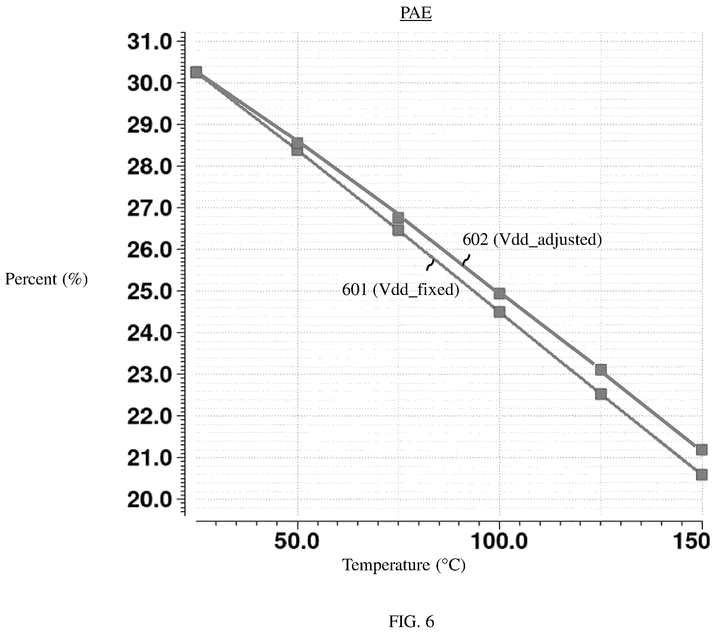

FIG. 6 is a graph illustrating that a temperature-dependent drop in PAE, between 25 °C and 150 °C, may also be reduced with Vdd boosting at higher operating temperatures as described above (see the %-temperature curve 602) as compared to without such Vdd boosting (see the %-temperature curve 601). For example, the drop in PAE may be as much as ~9.5 % points when using a fixed Vdd across the range of operating temperatures from t1 (e.g., 25 °C) to t6 (e.g., 150 °C) and may be reduced to ~9.0 % points or less when boosting the voltage level of Vdd at higher operating temperatures.

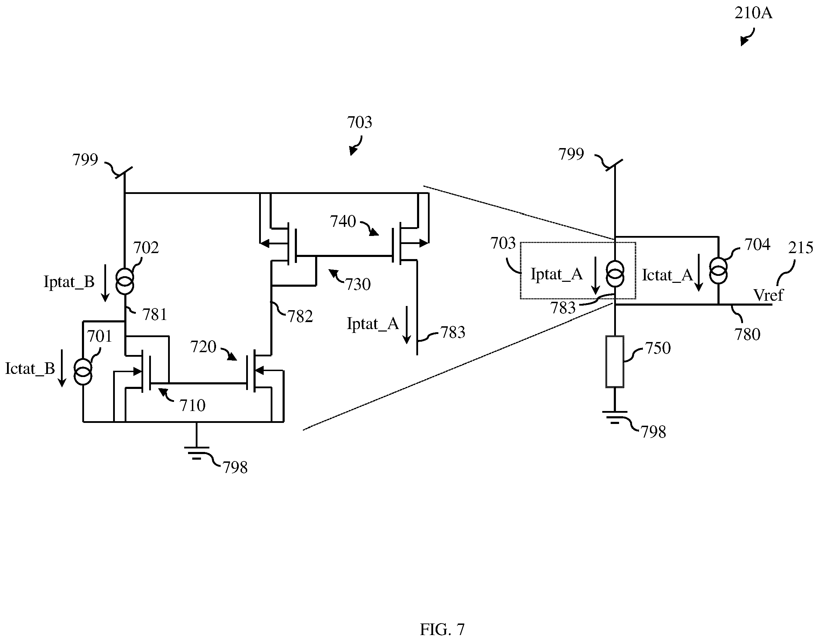

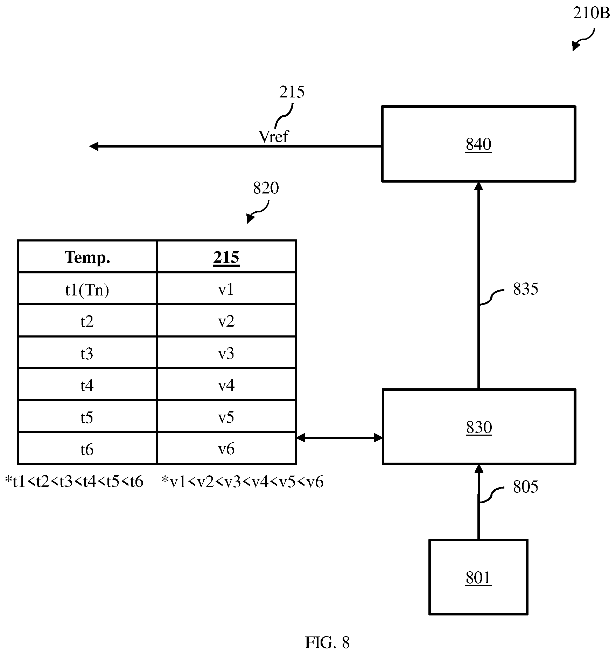

It should be noted that, in different embodiments of structure 200 of FIG. 2, first voltage generator 210 could have any suitable configuration to achieve the above-described temperature-dependent Vref profile. For example, in some embodiments a first voltage generator 210A, as illustrated in FIG. 7 and described in greater detail below, could be incorporated into power supply system 250. This first voltage generator 210A can use a combination of proportional-to-absolute-temperature (PTAT) and constant-to-absolute temperature (CTAT) current sources to achieve the temperature-dependent Vref profile. In other embodiments, a first voltage generator 210B, as illustrated in FIG. 8 and detailed discussion below, could be incorporated into power supply system 250. This first voltage generator 210B can use a look-up table (LUT) to achieve the temperature-dependent Vref profile.

More specifically, FIG. 7 is a schematic diagram illustrating one example of a first voltage generator 210A that could be incorporated into PSS 250. As illustrated, first voltage generator 210A can include a primary PTAT current source 703 and a resistor 750, which are electrically connected in series between a first voltage rail 799 (e.g., a positive voltage rail) and a second voltage rail 798 (e.g., a ground rail). First voltage generator 210A can further include a reference voltage output node 780 at a junction between primary PFET current source 703 and resistor 750. First voltage generator 210A can further include a primary CTAT current source 704, which is electrically connected in parallel with primary PTAT current source 703 between first voltage rail 799 and reference voltage output node 780. Primary PTAT current source 703 can provide a primary PTAT current (Iptat_A) and primary CTAT current source 704 can provide a primary CTAT current (Ictat_A) to reference voltage output node 780. Positive voltage rail 799 can be, for example, at a fixed positive voltage level (e.g., equal to a base power supply voltage level, such as at 1.6 volts (V)).

Those skilled in the art will recognize that a PTAT current source refers to a device that generates a variable current, where changes in the current level are proportional to changes in temperature. A CTAT current source refers to a device that generates a constant current (i.e., the current level remains the same regardless of changes in temperature). Generally, various different configurations for PTAT current sources and CTAT current sources are well known in the art. Any CTAT current source capable of providing Ictat_A at the desired constant current level can be incorporated into first voltage generator 210A. However, in the disclosed embodiments, primary PTAT current source 703 can specifically be configured to achieve a particular temperature-dependent Iptat_A profile that will result in the temperature-dependent Vref profile, as described above.

Specifically, primary PTAT current source 703 can include a secondary PTAT current source 702 and a secondary CTAT current source 701, which are electrically connected in series between first voltage rail 799 and second voltage rail 798. Primary PTAT current source 703 can further include a first intermediate node 781 between secondary PTAT current source 702 and secondary CTAT current source 701 and a first N-type transistor 710 (e.g., a first N-type field effect transistor (NFET)), which is electrically connected in parallel with secondary CTAT current source 701 between first intermediate node 781 and second voltage rail 798. Primary PTAT current source 703 can further include a first P-type transistor 730 (e.g., a first P-type field effect transistor (PFET)) and a second N-type transistor 720 (e.g., a second NFET), which are electrically connected in series between first voltage rail 799 and second voltage rail 798. As illustrated, gates of first N-type transistor 710 and second N-type transistor 720 can be electrically connected to first intermediate node 781. Primary PTAT current source 703 can further include a second intermediate node 782 between first P-type transistor 730 and second N-type transistor 720 and an Iptat_A output node 783. Primary PTAT current source 703 can further include a second P-type transistor 740 (e.g., a second PFET), which is electrically connected between first voltage rail 799 and Iptat_A output node 783. As illustrated, the gates of first P-type transistor 730 and second P-type transistor 740 can be electrically connected to second intermediate node 782.

Within primary PTAT current source 703, secondary PTAT current source 702 can generate a secondary PTAT current (Iptat_B) and secondary CTAT current source 701 can generate a second CTAT current (Ictat_B). Secondary PTAT current source 702 can be configured so that: (a) when the operating temperature is at a nominal temperature level (Tn) (e.g., 25 °C), then Iptat_B will be 0.0 amperes (A); and (b) when the operating temperature rises to progressively higher temperature levels above Tn, then Iptat_B will increase proportionally. As a result, when the operating temperature is at Tn, first N-type transistor 710, second N-type transistor 720, first P-type transistor 730 and second P-type transistor 740 will be in off-states and Iptat_A at Iptat_A output node 783 will be at 0.0 A. However, when the operating temperature rises from Tn, first N-type transistor 710, second N-type transistor 720, first P-type transistor 730 and second P-type transistor 740 will turn on and Iptat_A at Iptat_A output node 783 will be equal to Iptat_B minus Ictat_B. Iptat_B will further change (e.g., continuously) to progressively higher current levels as the operating temperature rises to progressively higher temperature levels above Tn and, as a result, Iptat_ A will also change (e.g., continuously) to progressively higher current levels.

Furthermore, since primary PTAT current source 703 and primary CTAT current source 704 are electrically connected in parallel, when the operating temperature is at Tn (e.g., 25 °C) such that Iptat_A is at 0.0 A, Vref 215 on reference voltage output node 780 will be equal to the resistance (R) of resistor 750 times Ictat_A. As the operating temperature rises to progressively higher temperature levels above Tn and, thus, Iptat_A also rises above 0.0 A, Vref 215 at reference voltage output node 780 will be equal to R*(Iptat_A and Ictat_A). It should be understood that, during design of such a first voltage generator 210, devices for resistor 750, secondary CTAT current source 701, secondary PTAT current source 702 and primary CTAT current source 704 can be selected (e.g., from a cell library) to ensure that the temperature-dependent Iptat_A profile is sufficient to achieve the temperature-dependent Vref profile, as described above.

FIG. 8 is a schematic diagram illustrating another example of a first voltage generator 210B that could be incorporated into PSS 250. First voltage generator 210B can include a look-up table (LUT) 820. LUT 820 can be populated (e.g., during a calibration process) with a data indicating different operating temperature levels and a data indicating different reference voltage levels associated with the different operating temperature levels (e.g., t1-t6 associated with v1-v6, respectively) such that the relationship therebetween corresponds to the temperature-dependent Vref profile, described above.

First voltage generator 210B can further include a temperature sensor 801, a variable voltage source 840, and control logic 830 in communication with LUT 820, temperature sensor 801 and variable voltage source 840. Temperature sensor 801 can be an on-chip temperature sensor adjacent to PA 202. Temperature sensor 801 can be, for example, a silicon bandgap temperature sensor (e.g., a PTAT temperature sensor). Such temperature sensors are well known in the art and, thus, the details thereof have been omitted from this specification in order to allow the reader to focus on the salient aspects of the disclosed embodiments. Alternatively, temperature sensor 801 could be any other suitable temperature sensor, which is now known or subsequently developed. In any case, temperature sensor 801 can sense (e.g., measure) the operating temperature of PA 202 (e.g., as indicated by the local temperature adjacent to PA 202) and can output an electrical signal 805 (e.g., a voltage signal) indicative of the measured operating temperature to control logic 830. Variable voltage source 840 can selectively output Vref 215 at any one of multiple possible reference voltage levels (e.g., v1-v6) in response to a control signal 835 from control logic 830.

Control logic 830 can receive electrical signal 805 from temperature sensor 801, identify the particular reference voltage level (e.g., any of v1-v6) associated in LUT 820 with the operating temperature indicated by electrical signal 805, and output a control signal 835 to variable voltage source 840 indicative of that particular reference voltage level. That is, control logic 830 can cause variable voltage source 840 to output a Vref 215 at the particular reference voltage level, which is listed in LUT 820 as being associated with the operating temperature sensed by temperature sensor 801. Generally, circuits structures that include an LUT, a variable voltage source, and control logic, which controls the voltage output from the variable voltage source based on LUT acquired information, are known in the art. Thus, the details thereof have been omitted from this specification in order to allow the reader to focus on the salient aspects of the disclosed embodiments.

Referring again to structure 200 of FIG. 2, regardless of whether structure 200 includes first voltage generator 210A of FIG. 7 or 210B of FIG. 8 to output Vref 215 with the particular temperature-dependent Vref profile, second voltage generator 220 can be configured to receive Vref 215 from first voltage generator 210 and to generate and output Vdd 225 based on Vref 215 such that it has the particular Vref-dependent Vdd profile, described above. Second voltage generator 220 can be a direct current-to-direct current converter, a low-dropout regulator, etc. Such devices are well known in the art. Thus, details thereof have been omitted from the specification in order to allow the reader to focus on the salient aspects of the disclosed embodiments.

It should be understood that the figures and discussion thereof above are not intended to be limiting. Examples have been provided (e.g., see FIGs. 4-6 and discussion thereof) in which PSS 250 can output a temperature-dependent Vdd 225 at any of six different voltage levels, which are associated with six different operating temperatures (e.g., t1-t6), respectively. Alternatively, PSS 250 could output a temperature-dependent Vdd 225 at any number of two or more different voltage levels associated with any number of two or more different operating temperature levels, respectively (e.g., to balance tradeoffs between performance and, for example, cost, complexity, etc.).

It should be understood that in the method and structures described above, a semiconductor material refers to a material whose conducting properties can be altered by doping with an impurity. Exemplary semiconductor materials include, for example, silicon-based semiconductor materials (e.g., silicon, silicon germanium, silicon germanium carbide, silicon carbide, etc.) and III-V compound semiconductors (i.e., compounds obtained by combining group **III** elements, such as aluminum (Al), gallium (Ga), or indium (In), with group V elements, such as nitrogen (N), phosphorous (P), arsenic (As) or antimony (Sb)) (e.g., GaN, InP, GaAs, or GaP). A pure semiconductor material and, more particularly, a semiconductor material that is not doped with an impurity for the purposes of increasing conductivity (i.e., an undoped semiconductor material) is referred to in the art as an intrinsic semiconductor. A semiconductor material that is doped with an impurity for the purposes of increasing conductivity (i.e., a doped semiconductor material) is referred to in the art as an extrinsic semiconductor and will be more conductive than an intrinsic semiconductor made of the same base material. That is, extrinsic silicon will be more conductive than intrinsic silicon; extrinsic silicon germanium will be more conductive than intrinsic silicon germanium; and so on. Furthermore, it should be understood that different impurities (i.e., different dopants) can be used to achieve different conductivity types (e.g., P-type conductivity and N-type conductivity) and that the dopants may vary depending upon the different semiconductor materials used. For example, a silicon-based semiconductor material (e.g., silicon, silicon germanium, etc.) is typically doped with a Group **III** dopant, such as boron (B) or indium (In), to achieve P-type conductivity, whereas a silicon-based semiconductor material is typically doped with a Group V dopant, such as arsenic (As), phosphorous (P) or antimony (Sb), to achieve N-type conductivity. A gallium nitride (GaN)-based semiconductor material is typically doped with magnesium (Mg) to achieve P-type conductivity and with silicon (Si) or oxygen to achieve N-type conductivity. Those skilled in the art will also recognize that different conductivity levels will depend upon the relative concentration levels of the dopant(s) in a given semiconductor region.

It should be understood that the terminology used herein is for the purpose of describing the disclosed structures and methods and is not intended to be limiting. For example, as used herein, the singular forms "a," "an," and "the" are intended to include the plural forms as well, unless the context clearly indicates otherwise. Additionally, as used herein, the terms "comprises," "comprising," "includes," and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The method as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a circuit structure including a power amplifier and a temperature-dependent power supply system for the power amplifier is disclosed. The power supply system includes a first voltage generator, which generates a reference voltage that is variable and depends on the operating temperature. In some embodiments, this first voltage generator employs a combination of proportional-to-absolute-temperature and constant-to-absolute temperature current sources to achieve the desired relationship between the operating temperature and the reference voltage. In other embodiments, a look-up table is employed to achieve the desired relationship between the operating temperature and the reference voltage. **In** any case, the power supply system also includes a second voltage generator, which is connected to receive the reference voltage and which generates (and outputs to the power amplifier) a power supply voltage that is dependent on the reference voltage.

The following embodiments are explicitly disclosed.
Embodiment 1:
   A structure comprising:
   a power amplifier; and
   a temperature-dependent power supply system including:
      a first voltage generator, wherein the first voltage generator generates a reference voltage dependent on an operating temperature; and
      a second voltage generator connected to receive the reference voltage, wherein the second voltage generator generates a power supply voltage dependent on the reference voltage, and wherein the power amplifier is connected to receive the power supply voltage.
Embodiment 2:
   The structure of embodiment 1,
   wherein the reference voltage is at a base reference voltage level when the operating temperature is at a nominal operating temperature level, and
   wherein the reference voltage changes to progressively higher reference voltage levels as the operating temperature rises to progressively higher temperature levels above the nominal operating temperature level.
Embodiment 3:
   The structure of embodiment 2,
   wherein the power supply voltage is at a base power supply voltage level when the reference voltage is at the base reference voltage level, and
   wherein the power supply voltage changes to progressively higher power supply voltage levels as the reference voltage changes to the progressively higher reference voltage levels.
Embodiment 4:
   The structure of embodiment 3, wherein, due to a relationship between the reference voltage and the power supply voltage, voltage swings of the power amplifier at different operating temperatures within a range of operating temperatures have approximately equal peak voltage levels.
Embodiment 5:
   The structure of embodiment 4, wherein, due to the approximately equal peak voltage levels of the voltage swings, drops in saturation power and power added efficiency in response to increases in the operating temperature are limited.
Embodiment 6:
   The structure of one of embodiments 1 to 5, wherein the base power supply voltage level is 1.6 volts (V), wherein the range of operating temperatures is from 25 °C to 150 °C, wherein the progressively higher power supply voltage levels rise from 1.6 V at 25 °C to 1.78 V at 150 °C, and wherein the peak voltage levels are at approximately 1.5 V.
Embodiment 7:
   The structure of one of embodiments 1 to 6, wherein the first voltage generator comprises:
   a reference voltage output node;
   a primary proportional-to-absolute-temperature (PTAT) current source providing a primary PTAT current and a primary constant-to-absolute-temperature (CTAT) current source providing a primary CTAT current, wherein the primary PTAT current source and the primary CTAT current source are connected in parallel between a first voltage rail and the reference voltage output node; and
   a resistor connected between the reference voltage output node and a second voltage rail, wherein the first voltage generator generates, at the reference voltage output node, a reference voltage dependent on an operating temperature,
   wherein the second voltage generator preferably includes any of a direct current-to-direct current converter and a low-dropout regulator.
Embodiment 8:
   A structure comprising:
   a power amplifier; and
   a temperature-dependent power supply system including:
      a first voltage generator including:
         a reference voltage output node;
         a primary proportional-to-absolute-temperature (PTAT) current source providing a primary PTAT current and a primary constant-to-absolute-temperature (CTAT) current source providing a primary CTAT current, wherein the primary PTAT current source and the primary CTAT current source are connected in parallel between a first voltage rail and the reference voltage output node; and
         a resistor connected between the reference voltage output node and a second voltage rail, wherein the first voltage generator generates, at the reference voltage output node, a reference voltage dependent on an operating temperature; and
      a second voltage generator connected to receive the reference voltage, wherein the second voltage generator generates a power supply voltage dependent on the reference voltage, and wherein the power amplifier connected to receive the power supply voltage.
Embodiment 9:
   The structure of embodiment 7 or 8, wherein the primary PTAT current source includes:
   a secondary PTAT current source providing a secondary PTAT current;
   a secondary CTAT current source providing a secondary CTAT current, wherein the secondary PTAT current source and the secondary CTAT current source are connected in series between the first voltage rail and the second voltage rail ;
   a first intermediate node between the secondary PTAT current source and the secondary CTAT current source;
   a first N-type transistor connected in parallel with the secondary CTAT current source between the first intermediate node and the second voltage rail;
   a first P-type transistor and a second N-type transistor connected in series between the first voltage rail and the second voltage rail, wherein gates of the first N-type transistor and the second N-type transistor are electrically connected to the first intermediate node;
   a second intermediate node between the first P-type transistor and the second N-type transistor;
   an output node; and
   a second P-type transistor connected between the first voltage rail and the output node, wherein gates of the first P-type transistor and the second P-type transistor are electrically connected to the second intermediate node, wherein the primary PTAT current is output on the output node.
Embodiment 10:
   The structure of embodiment 9,
   wherein, when the operating temperature is at a nominal operating temperature level, the primary PTAT current is at 0.0 amperes and the reference voltage is at a base reference voltage level equal to a resistance of the resistor times the primary CTAT current, and
   wherein, as the operating temperature rises to progressively higher temperature levels above the nominal operating temperature level:
      the secondary PTAT current rises to progressively higher secondary PTAT current levels,
      the primary PTAT current rises to progressively higher primary PTAT current levels equal to the secondary PTAT current minus the secondary CTAT current, and
      the reference voltage rises to progressively higher reference voltage levels equal to the resistance of the resistor times a sum of the primary PTAT current and the primary CTAT current.
Embodiment 11:
   The structure of embodiment 10,
   wherein the power supply voltage is at a base power supply voltage level when the reference voltage is at the base reference voltage level, and
   wherein the power supply voltage changes to progressively higher power supply voltage levels as the reference voltage changes to the progressively higher reference voltage levels.
Embodiment 12:
   The structure of embodiment 11, wherein, due to a relationship between the reference voltage and the power supply voltage, voltage swings of the power amplifier at different operating temperatures have approximately equal peak voltage levels.
Embodiment 13:
   The structure of embodiment 12, wherein, due to the approximately equal peak voltage levels of the voltage swings, drops in saturation power drop and power added efficiency in response to increases in the operating temperature are limited.
Embodiment 14:
   The structure of embodiment 12 or 13, wherein the base power supply voltage level is 1.6 volts (V), wherein the range of operating temperatures is from 25 °C to 150 °C, wherein the progressively higher power supply voltage levels increase from 1.6 V at 25 °C to 1.78 V at 150 °C, and wherein the peak voltage levels are at approximately 1.5 V.
Embodiment 15:
   The structure of one of embodiments 7 to 13, wherein the second voltage generator includes any of a direct current-to-direct current converter and a low-dropout regulator.
Embodiment 16:
   The structure of one of embodiments 1 to 15, wherein the first voltage generator comprises:
   a temperature sensor;
   a variable voltage source;
   a look-up table populated with a list of different operating temperatures and different reference voltages associated with the different operating temperatures, respectively; and control logic connected the temperature sensor, the look-up table, and the variable voltage source, wherein the control logic causes the variable voltage source to output a reference voltage listed in the look-up table and associated with an operating temperature sensed the temperature sensor.
Embodiment 17:
   A structure comprising:
   a power amplifier; and
   a temperature-dependent power supply system including:
      a first voltage generator including:
         a temperature sensor;
         a variable voltage source;
         a look-up table populated with a list of different operating temperatures and different reference voltages associated with the different operating temperatures, respectively; and
         control logic connected the temperature sensor, the look-up table, and the variable voltage source, wherein the control logic causes the variable voltage source to output a reference voltage listed in the look-up table and associated with an operating temperature sensed the temperature sensor; and
      a second voltage generator connected to receive the reference voltage, wherein the second voltage generator generates a power supply voltage dependent on the reference voltage, and wherein the power amplifier connected to receive the power supply voltage.
Embodiment 18:
   The structure of embodiment 16 or 17,
   wherein the reference voltage is at a base reference voltage level when the operating temperature is at a nominal operating temperature level, and
   wherein the reference voltage changes to progressively higher reference voltage levels as the operating temperature rises to progressively higher temperature levels above the nominal operating temperature level.
Embodiment 19:
   The structure of one of embodiments 16 or 18,
   wherein the power supply voltage is at a base power supply voltage level when the reference voltage is at the base reference voltage level, and
   wherein the power supply voltage changes to progressively higher power supply voltage levels as the reference voltage changes to the progressively higher reference voltage levels.
Embodiment 20:
   The structure of one of embodiments 16 to 19, wherein, due to a relationship between the reference voltage and the power supply voltage, voltage swings of the power amplifier at different operating temperatures have approximately equal peak voltage levels.
Embodiment 21:
   The structure of one of embodiments 16 to 20, wherein, due to the approximately equal peak voltage levels of the voltage swings, drops in saturation power and power added efficiency in response to increases in the operating temperature are limited.
Embodiment 22:
   The structure of one of embodiments 16 to 21, wherein the base power supply voltage level is 1.6 volts (V), wherein the range of operating temperatures is from 25 °C to 150 °C, wherein the progressively higher power supply voltage levels increase from 1.6 V at 25 °C to 1.78 V at 150 °C, and wherein the peak voltage levels are at approximately 1.5 V.

## Claims

1. A structure comprising:
a power amplifier; and
a temperature-dependent power supply system including:
a first voltage generator, wherein the first voltage generator generates a reference voltage dependent on an operating temperature; and
a second voltage generator connected to receive the reference voltage, wherein the second voltage generator generates a power supply voltage dependent on the reference voltage, and wherein the power amplifier is connected to receive the power supply voltage.

2. The structure of claim 1,
wherein the reference voltage is at a base reference voltage level when the operating temperature is at a nominal operating temperature level, and
wherein the reference voltage changes to progressively higher reference voltage levels as the operating temperature rises to progressively higher temperature levels above the nominal operating temperature level.

3. The structure of claim 2,
wherein the power supply voltage is at a base power supply voltage level when the reference voltage is at the base reference voltage level, and
wherein the power supply voltage changes to progressively higher power supply voltage levels as the reference voltage changes to the progressively higher reference voltage levels.

4. The structure of claim 3, wherein, due to a relationship between the reference voltage and the power supply voltage, voltage swings of the power amplifier at different operating temperatures within a range of operating temperatures have approximately equal peak voltage levels.

5. The structure of claim 4, wherein, due to the approximately equal peak voltage levels of the voltage swings, drops in saturation power and power added efficiency in response to increases in the operating temperature are limited, and/or wherein the base power supply voltage level is 1.6 volts (V), wherein the range of operating temperatures is from 25 °C to 150 °C, wherein the progressively higher power supply voltage levels rise from 1.6 V at 25 °C to 1.78 V at 150 °C, and wherein the peak voltage levels are at approximately 1.5 V.

6. The structure of one of claims 1 to 5, wherein the first voltage generator comprises:
a reference voltage output node;
a primary proportional-to-absolute-temperature (PTAT) current source providing a primary PTAT current and a primary constant-to-absolute-temperature (CTAT) current source providing a primary CTAT current, wherein the primary PTAT current source and the primary CTAT current source are connected in parallel between a first voltage rail and the reference voltage output node; and
a resistor connected between the reference voltage output node and a second voltage rail, wherein the first voltage generator generates, at the reference voltage output node, a reference voltage dependent on an operating temperature,
wherein the second voltage generator preferably includes any of a direct current-to-direct current converter and a low-dropout regulator.

7. The structure of claim 6, wherein the primary PTAT current source includes:
a secondary PTAT current source providing a secondary PTAT current;
a secondary CTAT current source providing a secondary CTAT current, wherein the secondary PTAT current source and the secondary CTAT current source are connected in series between the first voltage rail and the second voltage rail ;
a first intermediate node between the secondary PTAT current source and the secondary CTAT current source;
a first N-type transistor connected in parallel with the secondary CTAT current source between the first intermediate node and the second voltage rail;
a first P-type transistor and a second N-type transistor connected in series between the first voltage rail and the second voltage rail, wherein gates of the first N-type transistor and the second N-type transistor are electrically connected to the first intermediate node;
a second intermediate node between the first P-type transistor and the second N-type transistor;
an output node; and
a second P-type transistor connected between the first voltage rail and the output node, wherein gates of the first P-type transistor and the second P-type transistor are electrically connected to the second intermediate node, wherein the primary PTAT current is output on the output node.

8. The structure of claim 7,
wherein, when the operating temperature is at a nominal operating temperature level, the primary PTAT current is at 0.0 amperes and the reference voltage is at a base reference voltage level equal to a resistance of the resistor times the primary CTAT current, and
wherein, as the operating temperature rises to progressively higher temperature levels above the nominal operating temperature level:
the secondary PTAT current rises to progressively higher secondary PTAT current levels,
the primary PTAT current rises to progressively higher primary PTAT current levels equal to the secondary PTAT current minus the secondary CTAT current, and
the reference voltage rises to progressively higher reference voltage levels equal to the resistance of the resistor times a sum of the primary PTAT current and the primary CTAT current.

9. The structure of claim 8,
wherein the power supply voltage is at a base power supply voltage level when the reference voltage is at the base reference voltage level, and
wherein the power supply voltage changes to progressively higher power supply voltage levels as the reference voltage changes to the progressively higher reference voltage levels.

10. The structure of claim 9, wherein, due to a relationship between the reference voltage and the power supply voltage, voltage swings of the power amplifier at different operating temperatures have approximately equal peak voltage levels.

11. The structure of claim 10, wherein, due to the approximately equal peak voltage levels of the voltage swings, drops in saturation power drop and power added efficiency in response to increases in the operating temperature are limited, and/or wherein the base power supply voltage level is 1.6 volts (V), wherein the range of operating temperatures is from 25 °C to 150 °C, wherein the progressively higher power supply voltage levels increase from 1.6 V at 25 °C to 1.78 V at 150 °C, and wherein the peak voltage levels are at approximately 1.5 V.

12. The structure of one of claims 1 to 11, wherein the first voltage generator comprises:
a temperature sensor;
a variable voltage source;
a look-up table populated with a list of different operating temperatures and different reference voltages associated with the different operating temperatures, respectively; and
control logic connected the temperature sensor, the look-up table, and the variable voltage source, wherein the control logic causes the variable voltage source to output a reference voltage listed in the look-up table and associated with an operating temperature sensed the temperature sensor.

13. The structure of claim 12,
wherein the reference voltage is at a base reference voltage level when the operating temperature is at a nominal operating temperature level, and
wherein the reference voltage changes to progressively higher reference voltage levels as the operating temperature rises to progressively higher temperature levels above the nominal operating temperature level.

14. The structure of claim 12 or 13,
wherein the power supply voltage is at a base power supply voltage level when the reference voltage is at the base reference voltage level, and
wherein the power supply voltage changes to progressively higher power supply voltage levels as the reference voltage changes to the progressively higher reference voltage levels.

15. The structure of one of claims 12 to 14, wherein, due to a relationship between the reference voltage and the power supply voltage, voltage swings of the power amplifier at different operating temperatures have approximately equal peak voltage levels, and/or
wherein the base power supply voltage level is 1.6 volts (V), wherein the range of operating temperatures is from 25 °C to 150 °C, wherein the progressively higher power supply voltage levels increase from 1.6 V at 25 °C to 1.78 V at 150 °C, and
wherein the peak voltage levels are at approximately 1.5 V,
wherein, due to the approximately equal peak voltage levels of the voltage swings, drops in saturation power and power added efficiency in response to increases in the operating temperature are preferably limited.
